# EUROPEAN PATENT APPLICATION

(11) **EP 3 067 787 A1**
(43) Date of publication of application: **14.09.2016**
(21) Application number: 16160015.0
(22) Date of filing: 11.03.2016
(51) Int. Cl.: G06F 3/041, H01L 51/52, H01L 27/32, H05K 3/02

(54) **ACTIVE MATRIX ORGANIC LIGHT-EMITTING DIODE PANEL AND METHOD FOR PRODUCING**

(30) Priority: 13.03.2015 CN 201510109875
(71) Applicant: EverDisplay Optronics (Shanghai) Limited, Shanghai 201508 (CN)
(72) Inventor: ZHAO, Xiaohu, Shanghai 201508 (CN); ZHAI, Hongfeng, Shanghai 201508 (CN); LIN, Maochung, Shanghai 201508 (CN); WANG, Yenlong, Shanghai 201508 (CN)
(74) Representative: Szabo, Zsolt

(57) **Abstract**

An AMOLED panel and a method for producing the AMOLED panel are disclosed. The AMOLED panel includes a touch control cover with a detecting function. An AMOLED substrate includes array substrate, a lighting unit mounted on the array substrate, and an integrated circuit connected to and controlling the lighting unit. The touch control cover is electrically connected to the integrated circuits. An encapsulant layer is mounted between the touch control cover and the AMOLED substrate to sealingly connect the touch control cover with the AMOLED substrate. Since the encapsulant layer contacts the touch control cover, the touch control cover and the encapsulant layer are on the same side during the packaging process, avoiding the risk of scratch. The integrated circuit mounted on the array substrate is electrically connected to the touch control cover, such that the disposition of the integrated circuit on the AMOLED panel is proceeded only once.

## Description

### BACKGROUND OF THE INVENTION

The present disclosure relates to the display field and, more particularly, to an active matrix organic light-emitting diode (AMOLED) panel and a method for producing the AMOLED panel.

Organic light-emitting diodes (also known as organic electroluminescence) include the features of self-illumination and use a very thin coating of organic material and a very thin glass substrate. The organic material emits light when electric current passes through. In comparison with conventional liquid crystal panels, active matrix organic light-emitting diode (AMOELD) panels include the features of high speed response, high contrast, and broad view. Furthermore, due to the feature of self-illumination, AMOLED panels do not require backlight plates and are, thus, thinner and lighter than conventional liquid crystal panels while saving the costs for backlight modules. These advantages give AMOLED panels a promising application future.

With the rapid progress of display technologies, display devices with touch control functions become more popular due to advantages thereof, such as visualized operation. The touch control panels used in current mass-produced AMOLED products are on cell type touch control panels having disadvantages. Firstly, the touch control transducer serving as the medium for transmitting the touch control signals contacts the processing equipment during the packaging process, resulting in the risk of scratch. Secondly, the junction area between the touch control transducer and the integrated circuit requires a special design to avoid influence in the laser sealing process. Thirdly, the panels require respective integrated circuits in the cover and the substrate, which is a complicated technique.

### BRIEF SUMMARY OF THE INVENTION

An objective of the present disclosure is to overcome the deficiencies of the prior art by providing an AMOLED panel and a method for producing the AMOLED panel to solve the problems including the risk of scratch of the touch control transducer in the conventional AMOLED structure, the need of special design to avoid influence in the laser sealing process, and the need of two procedures for forming the integrated circuits in the panel.

In a first aspect, an AMOLED panel according to the present disclosure includes:
a touch control cover with a detecting function;
an active matrix organic light-emitting diode substrate including an array substrate, a lighting unit mounted on the array substrate, an integrated circuit connected to and controlling the lighting unit, a transmission line electrically connected to the integrated circuit, and a conductive protrusion electrically connected to the transmission line, with the conductive protrusion electrically connected to the touch control cover, and with the lighting unit including an anode layer, a cathode layer, and an organic emissive layer between the anode layer and the cathode layer; and
an encapsulant layer mounted around the touch control cover and the active matrix organic light-emitting diode substrate to sealingly connect the touch control cover with the active matrix organic light-emitting diode substrate.

Since the encapsulant layer contacts the touch control cover with a detecting function, the touch control cover and the encapsulant layer are on the same side during the packaging process, avoiding the risk of scratch. The integrated circuit is mounted on the array substrate and is electrically connected to the touch control cover, such that the disposition of the integrated circuit on the AMOLED panel according to the present disclosure is proceeded only once, simplifying the technical procedures required in the conventional technology. Furthermore, the transmission line and the array substrate are on the same side to avoid influence in the laser sealing process.

The conductive protrusion of the AMOLED panel can include a protrusion structure and a conductive film on the protrusion structure. The conductive film is electrically connected to the touch control cover and the transmission line. The conductive film and the cathode of the lighting unit are located on the same level.

In a second aspect, an AMOLED panel according to the present disclosure includes:
a touch control cover with a detecting function, with a touch control transducer and a conductive protrusion mounted on the touch control cover and electrically connected to each other;
an active matrix organic light-emitting diode substrate including an array substrate, a lighting unit mounted on the array substrate, and an integrated circuit connected to and controlling the lighting unit, with the lighting unit including an anode layer, a cathode layer, and an organic emissive layer between the anode layer and the cathode layer, and with the integrated circuit electrically connected to the conductive protrusion; and
an encapsulant layer mounted around the touch control cover and the active matrix organic light-emitting diode substrate to sealingly connect the touch control cover with the active matrix organic light-emitting diode substrate.

The active matrix organic light-emitting diode substrate can further include a transmission line electrically connected to the conductive protrusion and the integrated circuit.

In a third aspect, a method for producing an AMOLED panel according to the present disclosure includes:
providing an array substrate and producing a lighting unit and an integrated circuit on the array substrate to form an active matrix organic light-emitting diode substrate, with the integrated circuit controlling the lighting unit;
providing a touch control cover with a detecting function and electrically connecting the touch control cover to the integrated circuit; and
bonding the array substrate and the touch control cover together, with an encapsulant layer disposed between the array layer and the touch control cover.

Since the encapsulant layer contacts the touch control cover, the touch control cover and the encapsulant layer are on the same side during the packaging process, avoiding the risk of scratch of the touch control cover. The integrated circuit is mounted on the array substrate and is electrically connected to the touch control cover, such that the disposition of the integrated circuit on the AMOLED panel according to the present disclosure is proceeded only once, simplifying the technical procedures required in the conventional technology.

In an example, electrically connecting the touch control cover to the integrated circuit includes:
producing a transmission line on the array substrate and electrically connecting the transmission line to the integrated circuit;
producing a protrusion structure on the transmission line;
covering the protrusion structure and the transmission line with a metal conductive film, and electrically connecting the metal conductive film on the protrusion structure to the touch control cover; and
laser etching the metal conductive film to form independent circuits.

In another example, electrically connecting the touch control cover to the integrated circuit includes:
producing a protrusion structure on the touch control cover;
covering the protrusion structure and the touch control cover with a metal conductive film;
electrically connecting the metal conductive film to the integrated circuit; and laser etching the metal conductive film to form independent circuits.

A touch control transducer can be disposed between the metal conductive film and the touch control cover.

A transmission line can be produced on the array substrate and can be electrically connected to the metal conductive film on the protrusion structure. The transmission line is electrically connected to the integrated circuit.

The present disclosure will become clearer in light of the following detailed description of illustrative embodiments of this disclosure described in connection with the drawings.

Another objective of the present disclosure is that an encapsulant layer mounted around the touch control cover and the active matrix organic light-emitting diode substrate to sealingly connect the touch control cover with the active matrix organic light-emitting diode substrate.

Another objective of the present disclosure is that a touch control transducer is disposed between the touch control cover and the conductive film.

Another objective of the present disclosure is that an active matrix organic light-emitting diode panel comprising a touch control cover with a detecting function, with a conductive protrusion electrically connected to the touch control cover; an active matrix organic light-emitting diode substrate including an array substrate, a lighting unit mounted on the array substrate, and an integrated circuit connected to and controlling the lighting unit, with the lighting unit including an anode layer, a cathode layer, and an organic emissive layer between the anode layer and the cathode layer, and with the integrated circuit electrically connected to the conductive protrusion.

Another objective of the present disclosure is that an encapsulant layer mounted around the touch control cover and the active matrix organic light-emitting diode substrate to sealingly connect the touch control cover with the active matrix organic light-emitting diode substrate.

Another objective of the present disclosure is that the active matrix organic light-emitting diode substrate further includes a transmission line electrically connected to the conductive protrusion and the integrated circuit.

Still another objective of the present disclosure is that a touch control transducer is disposed between the touch control cover and the conductive protrusion..

Another objective of the present disclosure is that a method for producing an active matrix organic light-emitting diode panel, comprising:
providing an array substrate and producing a lighting unit and an integrated circuit on the array substrate to form an active matrix organic light-emitting diode substrate, with the integrated circuit controlling the lighting unit;
providing a touch control cover with a detecting function and electrically connecting the touch control cover to the integrated circuit; and
bonding the array substrate and the touch control cover together, with an encapsulant layer disposed between the array layer and the touch control cover.

Another objective of the present disclosure is that the step of touch control cover electrically connecting to the integrated circuit includes:
producing a transmission line on the array substrate and electrically connecting the transmission line to the integrated circuit;
producing a protrusion structure on the transmission line;
covering the protrusion structure and the transmission line with a metal conductive film, and electrically connecting the metal conductive film on the protrusion structure to the touch control cover; and
laser etching the metal conductive film to form independent circuits.

Another objective of the present disclosure is that electrically connecting the touch control cover to the integrated circuit includes:
producing a protrusion structure on the touch control cover;
covering the protrusion structure and the touch control cover with a metal conductive film;
electrically connecting the metal conductive film to the integrated circuit; and
laser etching the metal conductive film to form independent circuits.

Another objective of the present disclosure is that a touch control transducer is disposed between the metal conductive film and the touch control cover.

Another objective of the present disclosure is that the method comprises producing a transmission line on the array substrate and electrically connecting the transmission line to the metal conductive film on the protrusion structure, with the transmission line electrically connected to the integrated circuit.

### DESCRIPTION OF THE DRAWINGS

FIG. 1 is a diagrammatic view of an active matrix organic light-emitting diode panel of an embodiment according to the present disclosure.
FIG. 2 is a cross sectional view taken along section line A-A of FIG. 1.
FIGS. 3-6 are cross sectional views illustrating a method for producing an active matrix organic light-emitting diode panel of an embodiment according to the present disclosure.

### DETAILED DESCRIPTION OF THE DISCLOSURE

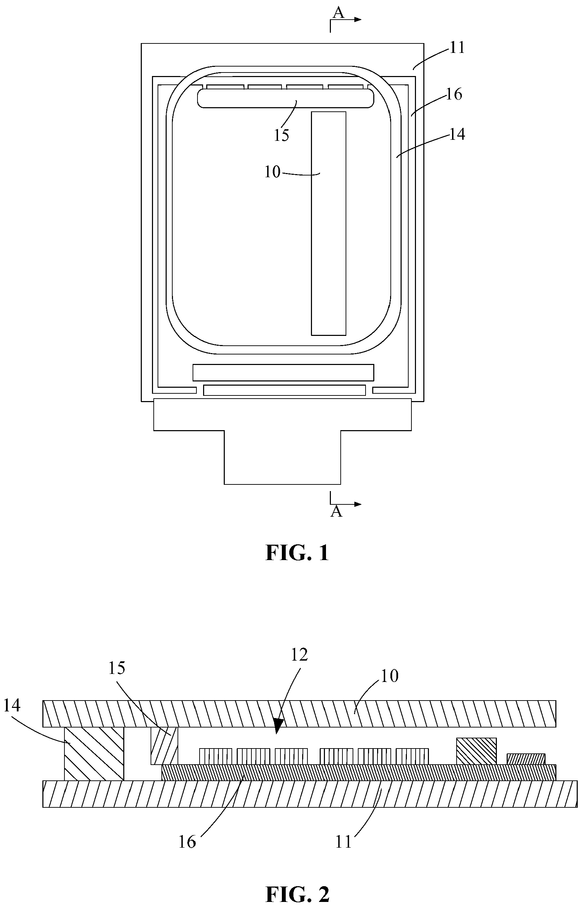

FIG. 1 is a diagrammatic view of an active matrix organic light-emitting diode (AMOLED) panel of an embodiment according to the present disclosure. The AMOLED panel according to the present disclosure includes a touch control cover 10, an AMOLED substrate, and an encapsulant layer 14. The touch control cover 10 is sealingly connected with the AMOLED substrate by the encapsulant layer 14. The touch control cover 10 with a detecting function contacting the encapsulant layer 14, such that the touch control cover 10 and the encapsulant layer 14 are on the same side during the packaging process, avoiding the risk of scratch. A lighting unit 12 and an integrated circuit controlling the lighting unit 12 are mounted on the AMOLED substrate. By electrically connecting the touch control cover to the integrated circuit, the touch control signal is sent to the integrated circuit, and the integrated circuit controls the lighting unit 12 to display. The AMOLED panel according to the present disclosure will be set forth more clearly in connection with the accompanying drawings.

The detailed structure of the AMOLED panel according to the present disclosure will now be set forth with reference to FIG. 1 showing the AMOLED panel of an embodiment according to the present disclosure.

As shown in FIG. 1, the AMOLED panel according to the present disclosure includes a touch control cover 10, an AMOLED substrate, and an encapsulant layer 14, as mentioned above. The touch control cover 10 has a detecting function and can be a cover with a touch control transducer. The AMOLED substrate includes an array substrate 11, a lighting unit 12, and an integrated circuit. The lighting unit 12 and the integrated circuit are mounted on the array substrate 11. The integrated circuit is connected to the lighting unit 12 and controls the lighting unit 12 to display. The touch control cover 10 is electrically connected to the integrated circuit. The touch control message detected by the touch control cover 10 is transmitted to the integrated circuit, and the integrated circuit controls the lighting unit 12 to display. The lighting unit 12 includes an anode layer, a cathode layer, and an organic emissive layer between the anode layer and the cathode layer. The encapsulant layer 14 is mounted between the touch control cover 10 and the AMOLED substrate. The encapsulant layer 14 is applied around the touch control cover 10 and the AMOLED substrate to sealingly connect the touch control cover 10 with the active matrix organic light-emitting diode substrate. Preferably, the encapsulant layer 14 is a frit. By bonding the touch control cover 10 to the AMOLED substrate by the encapsulant layer 14, the touch control cover 10 and the encapsulant layer 14 are on the same side during the packaging process, avoiding the scratch risk of the unit with the detecting function on the touch control cover 10. By mounting the integrated circuit on the array substrate 11, the disposition of the integrated circuit in present disclosure is proceeded only one time, simplifying the technical procedures required in the conventional technology.

FIG. 2 is a cross sectional view taken along section line A-A of FIG. 1. Further detailed structure of the AMOLED panel according to the present disclosure will now be set forth with reference to FIG. 2.

As shown in FIG. 2, in an embodiment of the present disclosure, the electrical connection between the touch control cover 10 and the integrated circuit is achieved by a conductive protrusion 15 and a transmission line 16. The conductive protrusion 15 is electrically connected to the touch control cover 10 and the transmission line 16. The transmission line 16 is electrically connected to the integrated circuit. Thus, the touch control message of the touch control cover 10 is transmitted to the integrated circuit, and the integrated circuit controls the lighting unit 12 to display. Preferably, a touch control transducer and the conductive protrusion 15 are mounted on the touch control cover 10. The touch control transducer is used to convert a physical signal received from the touch control cover 10 into an electrical signal. The conductive protrusion 15 is electrically connected to the touch control transducer and the integrated circuit and transmits the electrical signal converted by the touch control transducer to the integrated circuit. Then, the integrated circuit controls the lighting unit 12 to display according to the signal received. In this embodiment, the transmission line 16 is mounted on the AMOLED substrate and is electrically connected to the conductive protrusion 15 and the integrated circuit on the touch control cover 10, achieving the electrical connection between the conductive protrusion 15 and the integrated circuit.

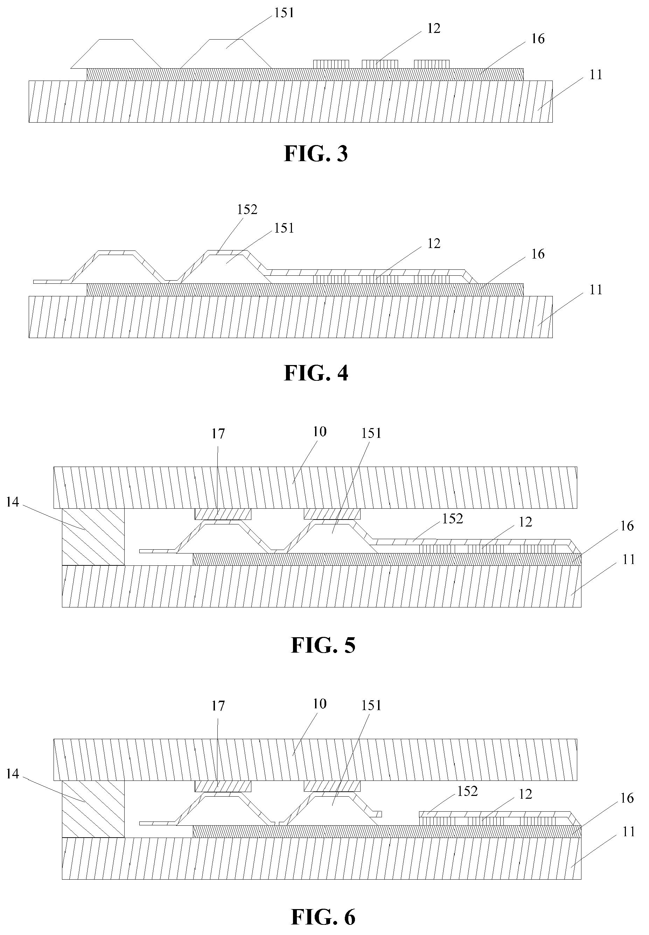

FIG. 6 shows an AMOLED of another embodiment according to the present disclosure. As shown in FIG. 6, the conductive protrusion and the transmission line 16 are mounted on the AMOLED substrate. Specifically, the transmission line 16 is mounted on the array substrate 11 and is electrically connected to the integrated circuit on the array substrate 11. The conductive protrusion is located above and electrically connected to the transmission line 16. A top of the conductive protrusion is electrically connected to the touch control cover 10 to achieve electrical connection between the touch control cover 10 and the integrated circuit. The transmission line 16 and the array substrate 10 are on the same side to avoid influence in the laser sealing process. Specifically, the conductive protrusion includes a protrusion structure 151 and a conductive film 152 on the protrusion structure 151, and the conductive film 152 is electrically connected to the touch control cover 10 and the transmission line 16, such that the conductive film 152 and the cathode of the lighting unit 12 are on the same level.

The advantageous effects of the AMOLED panel according to the present disclosure are that the AMOLED panel includes an in cell structure with a detection function (namely, an in cell type touch control panel), which can solve the deficiency of the on cell type touch control panel. Since the encapsulant layer contacts the touch control cover with a detecting function, the touch control cover and the encapsulant layer are on the same side during the packaging process, avoiding the risk of scratch. Furthermore, the transmission line and the array substrate are on the same side to avoid influence in the laser sealing process. Furthermore, the integrated circuit is mounted on the array substrate and is electrically connected to the touch control cover, such that the disposition of the integrated circuit on the AMOLED panel according to the present disclosure is proceeded only once, simplifying the technical procedures required in the conventional technology.

The present disclosure also provides a method for producing an AMOLED panel. The method includes:
providing an array substrate 11 and producing a lighting unit 12 and an integrated circuit on the array substrate 11 to form an active matrix organic light-emitting diode substrate, with the integrated circuit controlling the lighting unit;
providing a touch control cover 10 with a detecting function and electrically connecting the touch control cover 10 to the integrated circuit; and
bonding the array substrate 11 and the touch control cover 10 together, with an encapsulant layer 14 disposed between the array layer 11 and the touch control cover 10.

FIGS. 3-6 are cross sectional views illustrating a method for producing an AMOLED panel of an embodiment according to the present disclosure. An example of the method for producing an AMOLED panel according to the present disclosure will now be set forth with reference to FIGS. 3-6.

In this example, the lighting unit 12 and the integrated circuit are produced on the array substrate 11. As shown in FIG. 3, a transmission line 16 is produced on the array substrate 11 and is electrically connected to the integrated circuit. The lighting unit 12 is mounted on the transmission line 16 and can be controlled by the integrated circuit to display. A protrusion structure 151 is produced on the transmission line 16. The area of the top of the protrusion structure 151 is controlled to fulfill the requirement of a contact resistance.

As shown in FIG. 4, the array substrate 11 is then covered by a metal conductive film 152. The metal conductive film 152 covers the protrusion structure 151, the transmission line 16, and the lighting unit 12. The metal conductive film 152 is electrically connected to the transmission line 16. The metal conductive film 152 serves as the cathode of the AMOLED panel.

As shown in FIG. 5, the touch control cover 10 is mounted by pressing. The touch control cover 10 is bonded to the array substrate 11 by an encapsulant layer 14. The touch control cover 10 is electrically connected to the metal conductive film 152 on the protrusion structure 151 to achieve electrical connection between the touch control cover 10 and the transmission line 16, thereby achieving electrical connection between the touch control cover 10 and the integrated circuit. In an example, touch control transducers 17 are disposed between the metal conductive film 152 and the touch control cover 10. The touch control transducers 17 are used to convert a physical signal received from the touch control cover 10 into an electrical signal. The electrical signal is transmitted through the metal conductive film 152 to the transmission line 16 and then to the integrated circuit.

As shown in FIG. 6, laser etching is conducted on the metal conductive film 152 to make the transducers 17 independent from each other and to form independent circuits.

The AMOLED panel shown in FIG. 2 is produced by another example of the method for producing an AMOLED panel. In this example, electrically connecting the touch control cover 10 to the integrated circuit includes:
producing a protrusion structure on the touch control cover 10, wherein the protrusion structure faces the array substrate 11;
covering the protrusion structure and the touch control cover 10 with a metal conductive film;
electrically connecting the metal conductive film to the integrated circuit; and
laser etching the metal conductive film to form independent circuits.

In an example of the method according to the present disclosure, touch control transducers are mounted between the metal conductive film and the touch control cover and are electrically connected to the integrated circuit via the metal conductive film.

In an example of the method according to the present disclosure, a transmission line 16 is produced on the array line 11 and is electrically connected to the metal conductive film on the protrusion structure. The transmission line 16 is electrically connected to the integrated circuit.

The advantageous effects of the method for producing an AMOLED panel according to the present disclosure are that an AMOLED panel including an in cell structure with a detection function (namely, an in cell type touch control panel), which can solve the deficiency of the on cell type touch control panel, is obtained by the method for producing an AMOLED panel according to the present disclosure. Since the encapsulant layer contacts the touch control cover with a detecting function, the touch control cover and the encapsulant layer are on the same side during the packaging process, avoiding the risk of scratch. Furthermore, the transmission line and the array substrate are on the same side to avoid influence in the laser sealing process. Furthermore, the integrated circuit is mounted on the array substrate and is electrically connected to the touch control cover, such that the disposition of the integrated circuit on the AMOLED panel according to the present disclosure is proceeded only once, simplifying the technical procedures required in the conventional technology.

Thus since the illustrative embodiments disclosed herein may be embodied in other specific forms without departing from the spirit or general characteristics thereof, some of which forms have been indicated, the embodiments described herein are to be considered in all respects illustrative and not restrictive. The scope is to be indicated by the appended claims, rather than by the foregoing description, and all changes which come within the meaning and range of equivalency of the claims are intended to be embraced therein.

## Claims

1. An active matrix organic light-emitting diode panel comprising:
a touch control cover with a detecting function;
an active matrix organic light-emitting diode substrate including an array substrate, a lighting unit mounted on the array substrate, an integrated circuit connected to and controlling the lighting unit, a transmission line electrically connected to the integrated circuit, and a conductive protrusion electrically connected to the transmission line, with the conductive protrusion electrically connected to the touch control cover, and with the lighting unit including an anode layer, a cathode layer, and an organic emissive layer between the anode layer and the cathode layer.

2. The active matrix organic light-emitting diode panel according to claim 1, wherein an encapsulant layer mounted around the touch control cover and the active matrix organic light-emitting diode substrate to sealingly connect the touch control cover with the active matrix organic light-emitting diode substrate.

3. The active matrix organic light-emitting diode panel according to claim 1, with the conductive protrusion including a protrusion structure and a conductive film on the protrusion structure, with the conductive film electrically connected to the touch control cover and the transmission line, and with the conductive film and the cathode of the lighting unit located on a same level.

4. The active matrix organic light-emitting diode panel according to claim 3, wherein a touch control transducer is disposed between the touch control cover and the conductive film.

5. An active matrix organic light-emitting diode panel comprising:
a touch control cover with a detecting function;
a conductive protrusion electrically connected to the touch control cover;
an active matrix organic light-emitting diode substrate including an array substrate, a lighting unit mounted on the array substrate, and an integrated circuit connected to and controlling the lighting unit, with the lighting unit including an anode layer, a cathode layer, and an organic emissive layer between the anode layer and the cathode layer, and with the integrated circuit electrically connected to the conductive protrusion.

6. The active matrix organic light-emitting diode panel according to claim 4, wherein an encapsulant layer mounted around the touch control cover and the active matrix organic light-emitting diode substrate to sealingly connect the touch control cover with the active matrix organic light-emitting diode substrate.

7. The active matrix organic light-emitting diode panel according to claim 4, wherein the active matrix organic light-emitting diode substrate further includes a transmission line electrically connected to the conductive protrusion and the integrated circuit.

8. The active matrix organic light-emitting diode panel according to claim 7, wherein a touch control transducer is disposed between the touch control cover and the conductive protrusion.

9. A method for producing an active matrix organic light-emitting diode panel, comprising:
providing an array substrate and producing a lighting unit and an integrated circuit on the array substrate to form an active matrix organic light-emitting diode substrate, with the integrated circuit controlling the lighting unit;
providing a touch control cover with a detecting function and electrically connecting the touch control cover to the integrated circuit; and
bonding the array substrate and the touch control cover together, with an encapsulant layer disposed between the array layer and the touch control cover.

10. The method for producing an active matrix organic light-emitting diode panel according to claim 9, wherein the step of touch control cover electrically connecting to the integrated circuit includes:
producing a transmission line on the array substrate and electrically connecting the transmission line to the integrated circuit;
producing a protrusion structure on the transmission line;
covering the protrusion structure and the transmission line with a metal conductive film, and electrically connecting the metal conductive film on the protrusion structure to the touch control cover; and
laser etching the metal conductive film to form independent circuits.

11. The method for producing an active matrix organic light-emitting diode panel according to claim 10, wherein electrically connecting the touch control cover to the integrated circuit includes:
producing a protrusion structure on the touch control cover;
covering the protrusion structure and the touch control cover with a metal conductive film;
electrically connecting the metal conductive film to the integrated circuit; and
laser etching the metal conductive film to form independent circuits.

12. The method for producing an active matrix organic light-emitting diode panel according to claim 10, wherein a touch control transducer is disposed between the metal conductive film and the touch control cover.

13. The method for producing an active matrix organic light-emitting diode panel according to claim 10, further comprising producing a transmission line on the array substrate and electrically connecting the transmission line to the metal conductive film on the protrusion structure, with the transmission line electrically connected to the integrated circuit.
